# EUROPEAN PATENT APPLICATION

(11) **EP 4 768 961 A1**
(43) Date of publication of application: **01.07.2026**
(21) Application number: 25822489.8
(22) Date of filing: 12.05.2025
(51) Int. Cl.: G01R 31/392, G01R 31/367, G01R 31/382, G01R 31/396, G01R 19/10, G01R 19/165, G01R 19/00

(54) **BATTERY ABNORMALITY DIAGNOSIS DEVICE AND METHOD**

(30) Priority: 14.06.2024 KR 20240077533
(71) Applicant: LG Energy Solution, Ltd., Seoul 07335 (KR)
(72) Inventor: LIM, Geunwook, Daejeon 34122 (KR)
(74) Representative: Plasseraud IP
(86) International application number: PCT/KR2025/006329
(87) International publication number: WO 2025/258859

(57) **Abstract**

According to an embodiment of the present invention, a battery abnormality diagnosis device for individually diagnosing whether each of a plurality of batteries in a battery system is abnormal can monitor the state of the batteries, individually measure the voltage of the batteries if the state of at least one of the batteries satisfies a predefined diagnosis condition, perform individual balancing on the batteries, and diagnose the occurrence of an abnormality in at least one of the batteries on the basis of a voltage change before and after balancing of each of the batteries.

## Description

### [Technical Field]

This application claims priority to and the benefit of Korean Patent Application No.10-2024-0077533 filed in the Korean Intellectual Property Office on June 14, 2024 the entire contents of which are incorporated herein by reference.

The present invention relates to a battery abnormality diagnosis apparatus and method, and a system including the same, and more particularly, to a battery abnormality diagnosis apparatus and method that performs balancing to diagnose whether a battery abnormality occurs, independently of battery balancing to resolve an imbalance of batteries in a battery system.

### [Background Art]

As depletion of fossil fuels proceeds and interest in environmental pollution increases, importance of eco-friendly alternative energy source is gradually increasing. Among various alternative energy sources, demand for rechargeable battery systems is rapidly increasing.

Battery systems are being applied to various industrial fields from mobile application devices to vehicles, robots and energy storage devices, as a response to environmental regulations and high oil price issues.

In general, lithium secondary batteries are used for batteries, which leads to a risk of fire or explosion if an internal or external defect occurs. Therefore, it is important to diagnose the status of the batteries in real time.

A conventional battery system applied to the energy storage system diagnoses whether the battery has an abnormality based on the result of balancing control performed to resolve the imbalance of the batteries.

However, the balancing control in the conventional battery system is performed according to a command of an inverter or battery system controller, which is a higher control apparatus, or the battery management apparatus's own command, and thus, a disadvantage arises in that the abnormality diagnosis time and diagnosis criteria depend on the higher control apparatus.

Among the prior art documents relevant to the present invention, KR 10-2020-0009920 is of some relevance.

### [Detailed Description of the Invention]

### [Technical Problem]

To obviate one or more problems of the related art, embodiments of the present disclosure provide a battery abnormality diagnosis apparatus.

To obviate one or more problems of the related art, embodiments of the present disclosure also provide a battery abnormality diagnosis method.

To obviate one or more problems of the related art, embodiments of the present disclosure also provide a battery system.

### [Technical Solution]

In order to achieve the objective of the present disclosure, a battery abnormality diagnosis apparatus, for diagnosing whether each of a plurality of batteries in a battery system is abnormal, may include at least one processor; and a memory configured to store at least one instruction executed by the at least one processor, and the at least one instruction may include an instruction to monitor the status of the batteries; an instruction to individually measure voltages of the batteries when a status of at least one of the batteries satisfies a predetermined diagnosis condition; an instruction to perform individual balancing on the batteries; and an instruction to diagnose occurrence of an abnormality in at least one of the batteries based on voltage change before and after each of the batteries is balanced.

Here, the balancing may be performed independently from a balancing which is performed by a battery management apparatus in order to resolve an imbalance status of the batteries in the battery system.

Meanwhile, the instruction to diagnose the occurrence of an abnormality in at least one of the batteries may include an instruction to group the batteries into at least one battery group based on the individually measured voltage values of the batteries; an instruction to individually measure a voltage of each of the batteries after balancing; an instruction to individually calculate voltage difference values of respective batteries measured before and after balancing; and an instruction to diagnose whether an abnormality has occurred in a corresponding battery, by comparing the voltage difference value of corresponding battery with the voltage difference value of each of the batteries in the battery group to which the battery belongs so as to derive a comparison value and comparing the comparison value with a reference voltage drop value predetermined for the corresponding battery group.

Here, the instruction to diagnose whether an abnormality has occurred in the corresponding battery may include an instruction to calculate the comparison value by subtracting the voltage difference value of the corresponding battery from an average value of the voltage difference values of respective batteries in the battery group to which the corresponding battery belongs; an instruction to count the number of times an event occurs in which the comparison value is below the reference voltage drop value; and an instruction to determine that the corresponding battery is abnormal if the counted number of times of the corresponding battery is greater than or equal to a predetermined threshold number.

Meanwhile, according to embodiments, the instruction to individually measure the voltages of the batteries may include an instruction to compare the voltage of the batteries with a voltage predefined for performing balancing; and an instruction to individually measure the voltage of each of the batteries if the voltage of the batteries exceeds the voltage predefined for performing balancing.

Here, the instruction to individually measure the voltages of the batteries may include an instruction to check open circuit time of the batteries when the voltage of the batteries exceeds the voltage predefined for performing balancing; and an instruction to individually measure the voltage of each of the batteries when the open circuit time of the batteries exceeds a predetermined open circuit time.

Furthermore, the instruction to perform individual balancing on the batteries may include an instruction to perform individual balancing on the batteries until a predetermined balancing completion condition is satisfied.

Here, the balancing completion condition may include at least one of a time during which balancing is maintained in an operating state, a time during which a state of balancing termination is maintained, and a number of times the balancing is performed.

According to another embodiment of the present disclosure, a battery abnormality diagnosis method, using a battery abnormality diagnosis apparatus for diagnosing whether each of a plurality of batteries in a battery system is abnormal, may include monitoring the status of the batteries; individually measuring voltages of the batteries when a status of at least one of the batteries satisfies a predetermined diagnosis condition; performing individual balancing on the batteries; and diagnosing occurrence of an abnormality in at least one of the batteries based on voltage change before and after each of the batteries is balanced.

Here, the balancing may be performed independently from a balancing which is performed by a battery management apparatus in order to resolve an imbalance status of the batteries in the battery system.

Meanwhile, the diagnosing the occurrence of an abnormality in at least one of the batteries may include grouping the batteries into at least one battery group based on the individually measured voltage values of the batteries; individually measuring a voltage of each of the batteries after balancing; individually calculating voltage difference values of respective batteries measured before and after balancing; and diagnosing whether an abnormality has occurred in a corresponding battery, by comparing the voltage difference value of corresponding battery with the voltage difference value of each of the batteries in the battery group to which the battery belongs so as to derive a comparison value and comparing the comparison value with a reference voltage drop value predetermined for the corresponding battery group.

Here, the diagnosing whether an abnormality has occurred in the corresponding battery may include calculating the comparison value by subtracting the voltage difference value of the corresponding battery from an average value of the voltage difference values of respective batteries in the battery group to which the corresponding battery belongs; counting the number of times an event occurs in which the comparison value is below the reference voltage drop value; and determining that the corresponding battery is abnormal if the counted number of times of the corresponding battery is greater than or equal to a predetermined threshold number.

Meanwhile, the individually measuring the voltages of the batteries may include comparing the voltage of the batteries with a voltage predefined for performing balancing; and individually measuring the voltage of each of the batteries if the voltage of the batteries exceeds the voltage predefined for performing balancing.

Here, the individually measuring the voltages of the batteries may include checking open circuit time of the batteries when the voltage of the batteries exceeds the voltage predefined for performing balancing; and individually measuring the voltage of each of the batteries when the open circuit time of the batteries exceeds a predetermined open circuit time.

Furthermore, the performing individual balancing on the batteries may include performing individual balancing on the batteries until a predetermined balancing completion condition is satisfied.

Here, the balancing completion condition may include at least one of a time during which balancing is maintained in an operating state, a time during which a state of balancing termination is maintained, and a number of times the balancing is performed.

According to yet another embodiment of the present disclosure, a battery system may include a plurality of batteries; and a battery management apparatus configured to manage the plurality of batteries, wherein the battery management apparatus monitors the status of the batteries; individually measures voltages of the batteries when a status of at least one of the batteries satisfies a predetermined diagnosis condition; performs individual balancing on the batteries; and diagnoses occurrence of an abnormality in at least one of the batteries based on voltage change before and after each of the batteries is balanced.

### [Advantageous Effects]

According to embodiments of the present disclosure, it is possible to individually discharge batteries at a desired time and by a desired capacity by a manager of the battery system, and an abnormal battery detected is possible based on a voltage change measured after balancing control by individual discharge is completed, without relying on an upper control apparatus.

### [Brief Description of the Drawings]

FIG. 1 is a block diagram of an energy storage system to which embodiments of the present invention can be applied.
FIG. 2 is a block diagram of a battery system according to embodiments of the present invention.
FIG. 3 is a block diagram of a battery abnormality diagnosis apparatus according to embodiments of the present invention.
FIG. 4 is a flowchart of a battery abnormality diagnosis method according to embodiments of the present invention.
FIG. 5 is a flowchart for explaining a step of diagnosing whether an abnormality has occurred in the battery abnormality diagnosis methods according to embodiments of the present invention.
FIG. 6 is a table showing a reference voltage drop value for each battery group according to a voltage section according to an experimental example of the present invention.
FIG. 7 is a voltage change table of each of a plurality of batteries for abnormality diagnosis according to an experimental example of the present invention.
FIG. 8 is a graph showing the voltage difference values before and after balancing in FIG. 7 and an average value of the voltage difference values for each group, according to an experimental example of the present invention.

100: battery
200: Battery management apparatus
300: Battery abnormality diagnosis apparatus
310: memory
320: processor
330: transceiver
340: input interface device
350: output interface device
360: storage device
370: bus
S: battery system
D: upper control apparatus
CB: balancing circuit

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

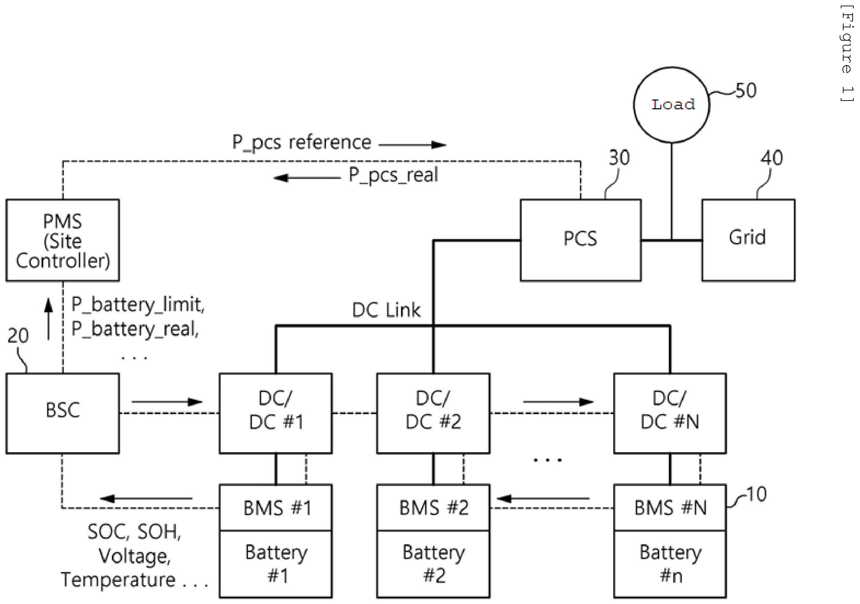

FIG. 1 is a block diagram of an energy storage system to which embodiments of the present invention can be applied.

Referring to FIG. 1, a basic unit of a battery that performs the role of storing power in an energy storage system (ESS) is typically a battery cell.

In general, a series/parallel combination of battery cells may form a battery module, and a plurality of battery modules may form a battery rack. In other words, a battery rack may be a basic unit of a battery system as a series/parallel combination of battery modules. Here, depending on a device or system in which the battery is used, the battery module may also be referred to as a battery pack. For example, Battery #1, Battery #2, ..., Battery #N illustrated in FIG. 1 may be in the form of a battery rack or a battery module (pack).

Here, a battery management apparatus (battery management system; BMS, 10) may be installed in each battery. The battery management apparatus 10 monitors the current, voltage, and temperature of each battery module (or rack) it manages, calculates the state of charge (SOC) based on monitoring results, and controls charging and discharging.

Meanwhile, a battery system controller (BSC, 20) may be installed in each battery system configured including a plurality of batteries and peripheral circuits, devices, etc. Accordingly, the battery system controller 20 may monitor and control targets to be controlled such as voltage, current, temperature, and circuit breakers within the battery system. In addition, the BSC 20 may calculate the output of each DC-DC converter based on the status information of the monitored battery section and transmit it to the DC-DC converter.

A power conversion system (PCS, 30) installed in each battery section may control the power supplied from the grid 40 and the power supplied from the battery 10 in order to supply the power required from the load 50. For example, the power conversion system 30 may be provided as a DC/AC inverter.

Meanwhile, communication (indicated by a dotted line in Fig. 1) may be performed among the battery, the battery management apparatus 10, the power conversion device 30, the grid 40, and the load 50 using Controller Area Network (CAN) or Ethernet.

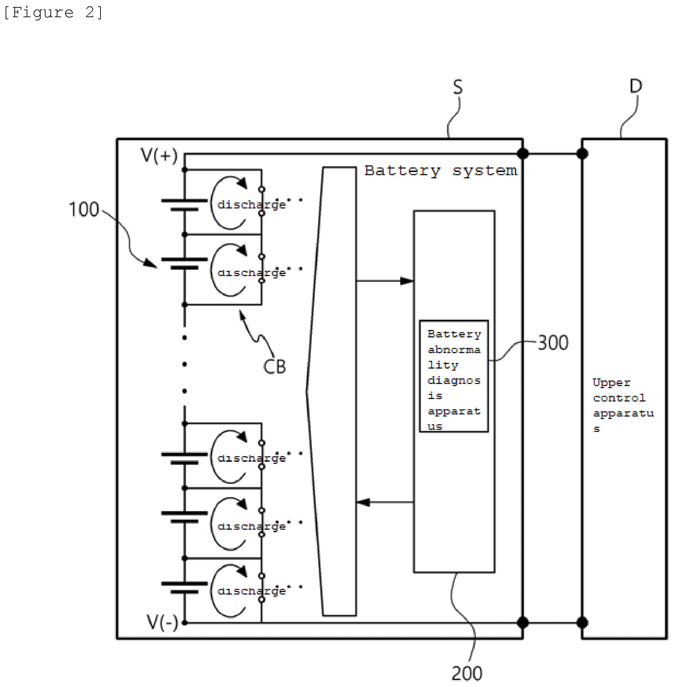

FIG. 2 is a block diagram of a battery system according to embodiments of the present invention.

Referring to FIG. 2, the battery system S may be applied to an energy storage system (ESS).

More specifically, the battery system S may include a plurality of batteries 100, a battery management apparatus 200, and a battery abnormality diagnosis apparatus 300.

The battery 100 may be one or more battery cells, and the plurality of batteries 100 may be provided in a form in which the battery cells are connected in series.

Each of the plurality of batteries 100 may include a balancing circuit (CB). Here, the balancing circuit (CB) may be a circuit used when performing a balancing operation by the battery management apparatus 200 to resolve an imbalance state of the batteries. Here, the balancing operation of the battery management apparatus 200 may be performed according to a control command of the upper control apparatus D, or by self-diagnosis of the battery management apparatus 200. Here, the upper control apparatus D may include an inverter or a battery system controller (BSC).

The battery management apparatus 200 may individually manage the states of the plurality of batteries 100. In addition, as described above, the battery management apparatus 200 may perform balancing on the plurality of batteries 100 according to the control command of the upper control apparatus D, or by self-diagnosis.

Meanwhile, the battery abnormality diagnosis apparatus 300 may perform independent balancing control on each of the plurality of batteries 100, separately from the balancing operation of the battery management apparatus 200 which is performed to resolve the imbalance of the batteries, by using the balancing circuit (CB).

In addition, the battery abnormality diagnosis apparatus 300 may diagnose whether an abnormality occurs in at least one of the batteries 100 through individual balancing control of each of the plurality of batteries 100.

Meanwhile, as disclosed, the battery abnormality diagnosis apparatus 300 may be provided as a separate configuration from the battery management apparatus 200, but may also be applied as a part of the battery management apparatus 200.

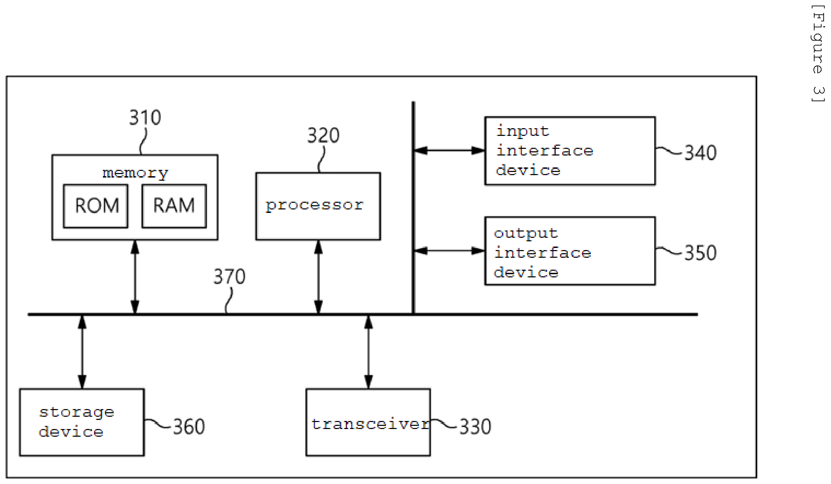

FIG. 3 is a block diagram of a battery abnormality diagnosis apparatus according to embodiments of the present invention.

Referring to FIG. 3, a battery abnormality diagnosis apparatus 300 may include a memory 310, a processor 320, a transceiver 330, an input interface device 340, an output interface device 350, and a storage device 360.

According to embodiments, each of the components 310, 320, 330, 430, 530, 630 included in the battery abnormality diagnosis apparatus may be connected by a bus 730 to communicate with each other.

Among the components 310, 320, 330, 430, 530, 630, the memory 310 and the storage device 360 may be configured to include at least one of a volatile storage medium and a nonvolatile storage medium. For example, the memory 310 and the storage device 360 may be configured with at least one of read-only memory (ROM) and random access memory (RAM).

Among these, the memory 310 may include at least one command executed by the processor 320.

A ccording to embodiments, the at least one instruction may include an instruction to monitor the status of the batteries; an instruction to individually measure voltages of the batteries when a status of at least one of the batteries satisfies a predetermined diagnosis condition; an instruction to perform individual balancing on the batteries; and an instruction to diagnose occurrence of an abnormality in at least one of the batteries based on voltage change before and after each of the batteries is balanced.

Here, the balancing is performed independently from a balancing which is performed by a battery management apparatus in order to resolve imbalance status of the batteries in the battery system.

Meanwhile, the instruction to diagnose the occurrence of an abnormality in at least one of the batteries may include an instruction to group the batteries into at least one battery group based on the individually measured voltage values of the batteries; an instruction to individually measure a voltage of each of the batteries after balancing; an instruction to individually calculate voltage difference values of respective batteries measured before and after balancing; and an instruction to diagnose whether an abnormality has occurred in a corresponding battery, by comparing the voltage difference value of corresponding battery with the voltage difference value of each of the batteries in the battery group to which the battery belongs so as to derive a comparison value and comparing the comparison value with a reference voltage drop value predetermined for the corresponding battery group.

Here, the instruction to diagnose whether an abnormality has occurred in the corresponding battery may include an instruction to calculate the comparison value by subtracting the voltage difference value of the corresponding battery from an average value of the voltage difference values of respective batteries in the battery group to which the corresponding battery belongs; an instruction to count the number of times an event occurs in which the comparison value is below the reference voltage drop value; and an instruction to determine that the corresponding battery is abnormal if the counted number of times of the corresponding battery is greater than or equal to a predetermined threshold number.

Meanwhile, according to embodiments, the instruction to individually measure the voltages of the batteries may include an instruction to compare the voltage of the batteries with a voltage predefined for performing balancing; and an instruction to individually measure the voltage of each of the batteries if the voltage of the batteries exceeds the voltage predefined for performing balancing.

Here, the instruction to individually measure the voltages of the batteries may include an instruction to check open circuit time of the batteries when the voltage of the batteries exceeds the voltage predefined for performing balancing; and an instruction to individually measure the voltage of each of the batteries when the open circuit time of the batteries exceeds a predetermined open circuit time.

Furthermore, the instruction to perform individual balancing on the batteries may include an instruction to perform individual balancing on the batteries until a predetermined balancing completion condition is satisfied.

Here, the balancing completion condition may include at least one of a time during which balancing is maintained in an operating state, a time during which a state of balancing termination is maintained, and a number of times the balancing is performed.

Meanwhile, the processor 320 may mean a central processing unit (CPU), a graphics processing unit (GPU), or a dedicated processor on which methods according to embodiments of the present invention are performed.

As described above, the processor 320 may execute at least one program command stored in the memory 310.

In the above, a battery abnormality diagnosis apparatus according to embodiments of the present invention has been described. In the following, an abnormality diagnosis method using the battery abnormality diagnosis apparatus will be described.

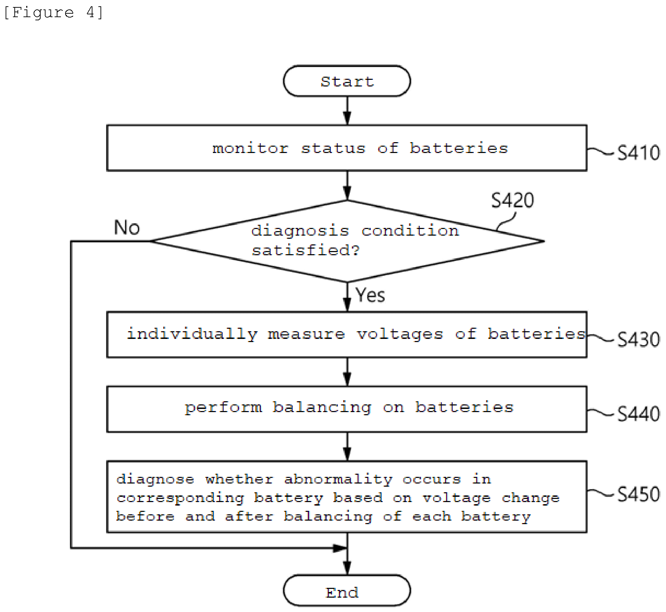

FIG. 4 is a flowchart of a battery abnormality diagnosis method according to embodiments of the present invention.

Referring to FIG. 4, a processor 320 in the battery abnormality diagnosis apparatus 300 may monitor the status of the plurality of batteries 100 (S410). Accordingly, the processor 320 may determine whether at least one battery among the plurality of batteries 100 satisfies a predetermined diagnosis condition (S420). Here, the diagnosis condition may include at least one of a voltage for performing balancing and an open circuit time.

According to one embodiment, the processor 320 may monitor the voltage of the plurality of batteries 100. For example, the processor 320 may monitor the voltage of the plurality of batteries 100 connected in series to determine whether the voltage of the plurality of batteries 100 exceeds a voltage predefined for performing balancing. Here, the voltage predefined for performing balancing may be defined as any one of a minimum voltage value, a maximum voltage value, and an average voltage value predefined for performing individual balancing of the batteries.

According to another embodiment, the processor 320 may monitor the voltages of the plurality of batteries 100 and the predefined open circuit time of each of the plurality of batteries 100. For example, the processor 320 may monitor voltages of the plurality of batteries 100 connected in series to determine whether the voltage of the plurality of batteries 100 exceed the voltage predefined for performing balancing. Here, if the voltage of the plurality of batteries 100 exceeds the voltage predefined for performing balancing, the processor 320 may monitor the predefined open circuit time of each of the plurality of batteries 100 to determine whether at least one of the plurality of batteries 100 exceeds the predefined open circuit time.

Thereafter, the processor 320 may individually measure the voltage of each of the plurality of batteries 100 (S430), if the status of the plurality of batteries 100 satisfies the predefined diagnostic condition (Y of S420). Here, the processor 320 may store the measured voltage of each of the plurality of batteries 100 in the storage device 360.

Thereafter, the processor 320 may perform balancing on the plurality of batteries 100 (S440).

According to embodiments, the processor 320 may individually perform balancing on the plurality of batteries 100 until each of them satisfies the balancing completion condition. For example, the processor 320 may discharge each of the plurality of batteries 100 until the balancing completion condition is satisfied.

Here, the balancing completion condition may include at least one of the time during which balancing is maintained in an operating state, the time during which a state of balancing termination is maintained, and a number of times the balancing is performed.

According to an embodiment, the processor 320 may terminate the balancing operation of a corresponding battery if the balancing operation maintaining time of at least one battery among the plurality of batteries is equal to or greater than a predetermined first set value.

According to another embodiment, the processor 320 may terminate the balancing operation of a corresponding battery if the number of times for which balancing is performed of at least one battery among the plurality of batteries is equal to or greater than a predetermined threshold number during a predetermined reference time.

According to yet another embodiment, the processor 320 may terminate balancing of a corresponding battery if, during a predetermined reference time, the balancing operation maintenance time of at least one battery among the plurality of batteries is equal to or greater than a first set value, the time for which balancing termination is maintained is equal to or greater than a second set value, and the number of balancing operations, during the predetermined reference time, is equal to or greater than a predetermined threshold number of times. Here, the first set value, the second set value, and the threshold number of times may be predefined by a manager.

Thereafter, the processor 320 may diagnose whether an abnormality occurs in the corresponding battery based on the voltage change before and after balancing of each of the plurality of batteries (S450).

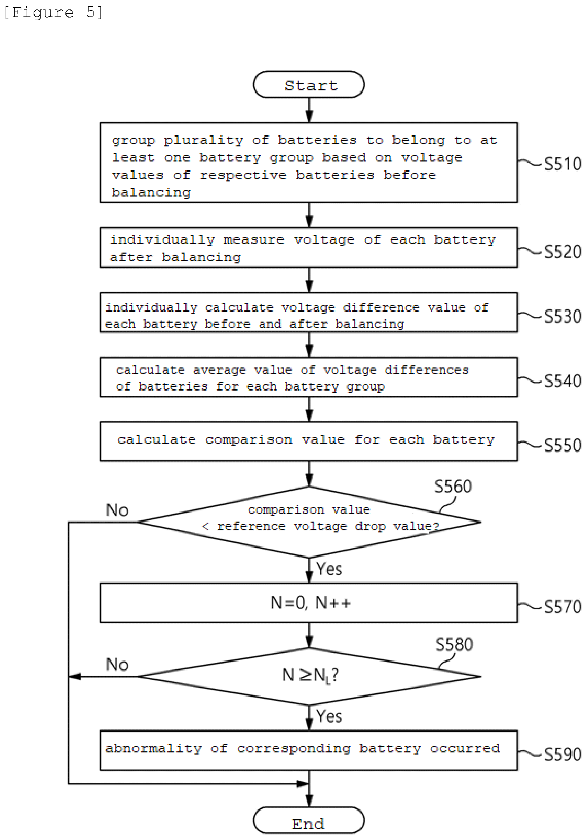

FIG. 5 is a flowchart for explaining a step of diagnosing whether an abnormality has occurred in the battery abnormality diagnosis methods according to embodiments of the present invention.

Referring to FIG. 5, the processor 320 may group each of the plurality of batteries 100 (S510) to belong to at least one battery group based on the voltage values measured in step S430 before performing balancing.

According to embodiments, the processor 320 may set a group of at least one battery belonging to a predetermined voltage range based on the voltage values of each of the plurality of batteries 100 measured before performing balancing. However, without being limited to what has been disclosed, the voltage range may be determined by the processor 320 based on the voltage values of each of the plurality of batteries 100 measured before performing balancing.

In addition, the processor 320 in the battery abnormality diagnosis apparatus according to embodiments of the present invention may first perform grouping before each of the plurality of batteries 100 performs balancing (step S440).

Thereafter, the processor 320 may individually measure the voltage values after the balancing is performed for each of the plurality of batteries 100 (S520).

Thereafter, the processor 320 may calculate the voltage change before and after the balancing of each of the plurality of batteries 100. For example, the processor 320 may calculate the voltage difference value by subtracting the voltage value measured after the balancing from the voltage value measured before the balancing is performed for each of the plurality of batteries 100 (S530).

Thereafter, the processor 320 may calculate an average value of the voltage differences of the batteries belonging to a corresponding battery group for each battery group (S540).

Thereafter, the processor 320 may calculate a comparison value for each of the plurality of batteries 100 (S550). Here, the comparison value may be a value obtained by subtracting the voltage difference value before and after the balancing of the corresponding battery from the average value of the voltage differences of the batteries in the battery group to which the corresponding battery belongs.

Thereafter, the processor 320 may compare the comparison value of the corresponding battery with a reference voltage drop value of the battery group to which the corresponding battery belongs (S560). Here, the processor 320 may recognize that an abnormality sign has occurred in the corresponding battery if the comparison value of the corresponding battery is below the reference voltage drop value and count this (N++) (S570).

In addition, the processor 320 may store information on the corresponding battery in the storage device (600). Here, the information may include location information and the counted number information of the corresponding battery.

Thereafter, the processor 320 may repeatedly perform steps S410 to S450 of FIG. 4, and diagnose that an abnormality has occurred in the corresponding battery (S590) if the counted number (N) is equal to or greater than a predetermined threshold number (N_{L}) (S580). Accordingly, the processor 320 may provide the corresponding battery information to the manager through the output interface device.

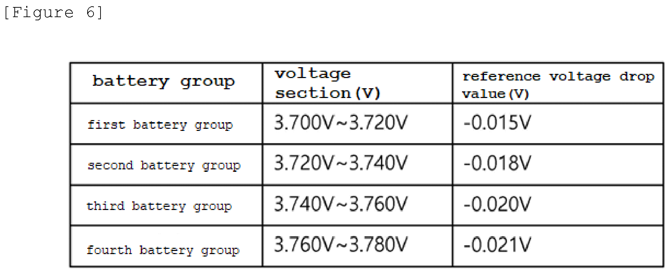

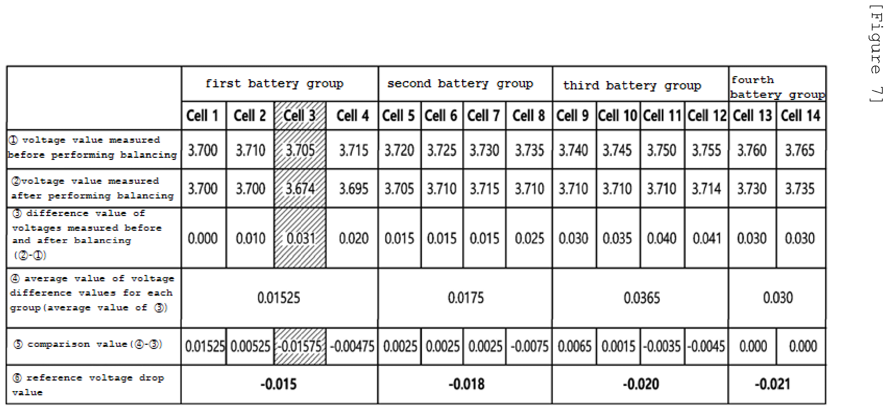

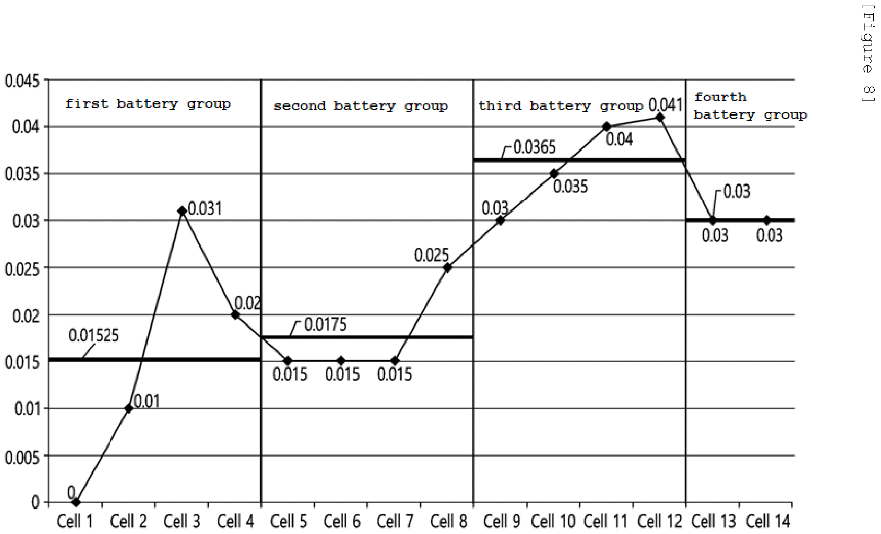

FIG. 6 is a table showing a reference voltage drop value for each battery group according to a voltage section according to an experimental example of the present invention, FIG. 7 is a voltage change table of each of a plurality of batteries for abnormality diagnosis according to an experimental example of the present invention, and FIG. 8 is a graph showing the voltage difference values before and after balancing in FIG. 7 and an average value of the voltage difference values for each group.

Referring to FIG. 6 to FIG. 8, the processor 320 may assign each of the plurality of batteries (Cell 1 to Cell 14) to one of at least one battery group using predefined voltage section information.

Describing in more detail according to embodiments, the processor 320 may individually assign the plurality of batteries (Cell 1 to Cell 14) to a plurality of battery groups (first to fourth battery groups) which is defined as predefined voltage sections based on the voltage value (①) of each of the plurality of batteries (Cell 1 to Cell 14) measured before performing balancing.

According to one embodiment, the processor 320 may assign at least one battery, which belongs to a range in which the voltage value before balancing is greater than or equal to 3.7 V and less than 3.720 V, to the first battery group. In other words, Cell 1, which has a voltage value of 3.7 V, Cell 2, which has a voltage value of 3.710 V, Cell 3, which has a voltage value of 3.705 V, and Cell 4, which has a voltage value of 3.715 V, may be assigned to the first battery group.

According to another embodiment, the processor 320 may assign at least one battery, which belongs to a range in which the voltage value before balancing is greater than or equal to 3.720 V and less than 3.740 V, to the second battery group. In other words, Cell 5, which has a voltage value measured before balancing of 3.720 V, Cell 6, which has a voltage value of 3.725 V, Cell 7, which has a voltage value of 3.730 V, and Cell 8, which has a voltage value of 3.735 V, may be assigned to the second battery group.

According to yet another embodiment, the processor 320 may assign at least one battery belonging to a range where the voltage value before balancing is greater than or equal to 3.740 V and less than 3.760 V to the third battery group. In other words, Cell 9, which has a voltage value measured before balancing of 3.740 V, Cell 10, has a voltage value of 3.745 V, Cell 11, which has a voltage value of 3.750 V, and Cell 12, which has a voltage value of 3.755 V, may be assigned to the third battery group.

According to yet another embodiment, the processor 320 may assign at least one battery belonging to a range where the voltage value before balancing is greater than or equal to 3.760 V and less than 3.780 V to the fourth battery group. In other words, Cell 13, which has a voltage value measured before balancing of 3.760 V and Cell 14, which has a voltage value of 3.765 V, may be assigned to the fourth battery group.

Thereafter, the processor 320 may individually measure (②) the voltages after balancing for Cell 1 to Cell 14, and calculate the voltage difference values (③) before and after balancing.

Thereafter, the processor 320 may calculate the average value (④) of the voltage difference values of the batteries belonging to the corresponding battery group for each battery group.

According to one embodiment, the average value of the voltage difference values before and after balancing of each of Cell 1 to Cell 4 belonging to the first battery group may be 0.0152 V.

According to another embodiment, the average value of the voltage difference values before and after balancing of each of Cell 5 to Cell 8 belonging to the second battery group may be 0.0175 V.

According to yet another embodiment, the average value of the voltage difference values before and after balancing of each of Cell 9 to Cell 12 belonging to the third battery group may be 0.0365 V.

According to yet another embodiment, the average value of the voltage difference values before and after balancing of each of Cell 13 and Cell 14 belonging to the fourth battery group may be 0.030 V.

Thereafter, the processor 320 may calculate a comparison values (⑤) by subtracting the average value of the battery group to which the corresponding battery belongs from the voltage difference values before and after balancing, for each of Cell 1 to Cell 14.

Thereafter, the processor 320 may individually compare the comparison values of Cell 1 to Cell 14 with the reference voltage drop value (⑥) defined for each battery group.

According to embodiments, the processor 320 may determine that an abnormality sign has occurred in the corresponding battery and count it, if at least one comparison value (⑤) of Cell 1 to Cell 14 is below the reference voltage drop value (⑥).

For example, in the case of Cell 3, the voltage difference value before and after balancing is 0.031 V, and the average difference value of the batteries (Cell 1 to Cell 4) in the first battery group to which Cell 3 belongs is 0.0152 V. Accordingly, the comparison value of Cell 3, which is obtained by subtracting the voltage difference value before and after balancing of Cell 3 from the average value of the batteries in the first battery group, is - 0.0158 V, which is lower than or equal to -0.015 V that is the reference voltage drop value of the first battery group. Therefore, the processor 320 may count an abnormality sign event in Cell 3.

Thereafter, the processor 320 may continuously perform balancing according to the status of multiple batteries, and it may determine that an abnormality has occurred in the corresponding battery, if the number of abnormality sign events counted for at least one battery is greater than or equal to a threshold number.

In the above, a battery abnormality diagnosis apparatus and method according to embodiments of the present invention, and a battery system including the same have been described.

The battery abnormality diagnosis apparatus and method according to embodiments of the present invention, and a battery system including the same, may independently perform individual balancing of each of a plurality of batteries according to a diagnosis condition, calculate a comparison value by comparing the voltage difference before and after balancing with an average value of the same battery group, and compare this with a reference voltage drop value, thereby enabling diagnosis of whether an abnormality has occurred in the corresponding battery.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery abnormality diagnosis apparatus for diagnosing whether each of a plurality of batteries in a battery system is abnormal, the battery abnormality diagnosis apparatus comprising:
at least one processor; and
a memory configured to store at least one instruction executed by the at least one processor,
wherein the at least one instruction includes:
an instruction to monitor the status of the batteries;
an instruction to individually measure voltages of the batteries when a status of at least one of the batteries satisfies a predetermined diagnosis condition;
an instruction to perform individual balancing on the batteries; and
an instruction to diagnose occurrence of an abnormality in at least one of the batteries based on voltage change before and after each of the batteries is balanced.

2. The battery abnormality diagnosis apparatus of claim 1, wherein the balancing is performed independently from a balancing which is performed by a battery management apparatus in order to resolve imbalance status of the batteries in the battery system.

3. The battery abnormality diagnosis apparatus of claim 2, wherein the instruction to diagnose the occurrence of an abnormality in at least one of the batteries includes:
an instruction to group the batteries into at least one battery group based on the individually measured voltage values of the batteries;
an instruction to individually measure a voltage of each of the batteries after balancing;
an instruction to individually calculate voltage difference values of respective batteries measured before and after balancing; and
an instruction to diagnose whether an abnormality has occurred in a corresponding battery, by comparing the voltage difference value of corresponding battery with the voltage difference value of each of the batteries in the battery group to which the battery belongs so as to derive a comparison value and comparing the comparison value with a reference voltage drop value predetermined for the corresponding battery group.

4. The battery abnormality diagnosis apparatus of claim 3, wherein the instruction to diagnose whether an abnormality has occurred in the corresponding battery includes:
an instruction to calculate the comparison value by subtracting the voltage difference value of the corresponding battery from an average value of the voltage difference values of respective batteries in the battery group to which the corresponding battery belongs;
an instruction to count the number of times an event occurs in which the comparison value is below the reference voltage drop value; and
an instruction to determine that the corresponding battery is abnormal if the counted number of times of the corresponding battery is greater than or equal to a predetermined threshold number.

5. The battery abnormality diagnosis apparatus of claim 1, wherein the instruction to individually measure the voltages of the batteries includes:
an instruction to compare the voltage of the batteries with a voltage predefined for performing balancing; and
an instruction to individually measure the voltage of each of the batteries if the voltage of the batteries exceeds the voltage predefined for performing balancing.

6. The apparatus of claim 5, wherein the instruction to individually measure the voltages of the batteries includes:
an instruction to check open circuit time of the batteries when the voltage of the batteries exceeds the voltage predefined for performing balancing; and
an instruction to individually measure the voltage of each of the batteries when the open circuit time of the batteries exceeds a predetermined open circuit time.

7. The battery abnormality diagnosis apparatus of claim 1, wherein the instruction to perform individual balancing on the batteries includes:
an instruction to perform individual balancing on the batteries until a predetermined balancing completion condition is satisfied.

8. The battery abnormality diagnosis apparatus of claim 7, wherein the balancing completion condition includes:
at least one of a time during which balancing is maintained in an operating state, a time during which a state of balancing termination is maintained, and a number of times the balancing is performed.

9. A battery abnormality diagnosis method using a battery abnormality diagnosis apparatus for diagnosing whether each of a plurality of batteries in a battery system is abnormal, the battery abnormality diagnosis method comprising:
monitoring the status of the batteries;
individually measuring voltages of the batteries when a status of at least one of the batteries satisfies a predetermined diagnosis condition;
performing individual balancing on the batteries; and
diagnosing occurrence of an abnormality in at least one of the batteries based on voltage change before and after each of the batteries is balanced.

10. The battery abnormality diagnosis method of claim 9, wherein the balancing is performed independently from a balancing which is performed by a battery management apparatus in order to resolve imbalance status of the batteries in the battery system.

11. The battery abnormality diagnosis method of claim 10, wherein the diagnosing the occurrence of an abnormality in at least one of the batteries includes:
grouping the batteries into at least one battery group based on the individually measured voltage values of the batteries;
individually measuring a voltage of each of the batteries after balancing;
individually calculating voltage difference values of respective batteries measured before and after balancing; and
diagnosing whether an abnormality has occurred in a corresponding battery, by comparing the voltage difference value of corresponding battery with the voltage difference value of each of the batteries in the battery group to which the battery belongs so as to derive a comparison value and comparing the comparison value with a reference voltage drop value predetermined for the corresponding battery group.

12. The battery abnormality diagnosis method of claim 11, wherein the diagnosing whether an abnormality has occurred in the corresponding battery includes:
calculating the comparison value by subtracting the voltage difference value of the corresponding battery from an average value of the voltage difference values of respective batteries in the battery group to which the corresponding battery belongs;
counting the number of times an event occurs in which the comparison value is below the reference voltage drop value; and
determining that the corresponding battery is abnormal if the counted number of times of the corresponding battery is greater than or equal to a predetermined threshold number.

13. The battery abnormality diagnosis method of claim 9, wherein the individually measuring the voltages of the batteries includes:
comparing the voltage of the batteries with a voltage predefined for performing balancing; and
individually measuring the voltage of each of the batteries if the voltage of the batteries exceeds the voltage predefined for performing balancing.

14. The battery abnormality diagnosis method of claim 13, wherein the individually measuring the voltages of the batteries includes:
checking open circuit time of the batteries when the voltage of the batteries exceeds the voltage predefined for performing balancing; and
individually measuring the voltage of each of the batteries when the open circuit time of the batteries exceeds a predetermined open circuit time.

15. The battery abnormality diagnosis method of claim 9, wherein the performing individual balancing on the batteries includes:
performing individual balancing on the batteries until a predetermined balancing completion condition is satisfied.

16. The battery abnormality diagnosis method of claim 15, wherein the balancing completion condition includes:
at least one of a time during which balancing is maintained in an operating state, a time during which a state of balancing termination is maintained, and a number of times the balancing is performed.

17. A battery system comprising:
a plurality of batteries; and
a battery management apparatus configured to manage the plurality of batteries,
wherein the battery management apparatus monitors the status of the batteries; individually measures voltages of the batteries when a status of at least one of the batteries satisfies a predetermined diagnosis condition; performs individual balancing on the batteries; and diagnoses occurrence of an abnormality in at least one of the batteries based on voltage change before and after each of the batteries is balanced.
